# EUROPEAN PATENT APPLICATION

(11) **EP 1 231 291 A1**
(43) Date of publication of application: **14.08.2002**
(21) Application number: 02003045.8
(22) Date of filing: 12.02.2002
(51) Int. Cl.: C23C 14/32, C23C 14/02, C23C 14/06, C23C 28/00

(54) **Process for forming decorative films and resulting products**

(30) Priority: 12.02.2001 US 781378
(71) Applicant: Ingersoll-Rand Company, Woodcliff Lake, New Jersey 07677 (US)
(72) Inventor: Hein, Gerald F., Ohio 45230 (US); Caballero, Manuel Mejia, Tecate B.C. (MX); Anderson, Al, South Carolina (US)
(74) Representative: Grünecker, Kinkeldey, Stockmair & Schwanhäusser Anwaltssozietät

(57) **Abstract**

Chrome, nickel, titanium or zirconium films; or combinations of those four metals, or a nitride, carbide or nitroxide of one of those four metals are deposited directly on unplated zinc or unplated zinc alloy substrates by physical vapor deposition in vacuum reactors. The nitroxides films have essentially the same colors as the nitrides but can have high electrical resistivities, transparency and other nonmetallic properties.

## Description

### BACKGROUND OF THE INVENTION

This invention relates to the process of forming films of decorative metals and ceramics on zinc and zinc alloy substrates. More particularly, the invention relates to the deposition of such films directly onto zinc and zinc alloys utilizing physical vapor deposition (PVD) technology. Reactors for conducting PVD manufacturing operations are well known and are widely used in the manufacture of decorative hardware coatings and other products utilizing cathodic arc and direct thermal evaporation sources. Substrates are defined as any object or product placed inside of a vacuum reactor, and onto which, a film is to be deposited in the reactor.

There is great commercial interest in creating metallic and ceramic metal layers or films on tools and decorative items, for example, door knobs, faucets and the like because of the visual appeal, resistance to corrosion and the hardness provided to the substrates on which these film layers are formed.

Reactors used for PVD can have a variety of shapes ranging from round to square to toroidal. Round reactors are exemplified by U.S. Patent No. 4,877,505 issued to Erich Bergmann, U.S. Patent No. 5,690,796 issued to Francois DuPont and U.S. Patent No. 6,045,667 issued to Eberhard Moll.

These patents teach that deposition processes can be done with a range of reactor shapes and equipment for creating desired vacuums within a reactor's enclosure. A "circle" of rotating pylons or "reels" may be used for positioning and rotating the substrate(s) during the coating process within the reactor. A plasma is created from arc sources within the enclosure. The plasma is the medium used for depositing material to form the coating. Practically speaking, the enclosure should have the arc sources positioned to optimize the creation of uniform, confined plasma.

U.S. Patent No. 5,370,737 issued to Reinhard Mathis is typical of another form of reactor. The Mathis reactor is in the form of a double walled toroid. The pylons which position the substrate products are positioned on a low, second toroid which rotates within the base of the enclosing toroid. Helical RF coils can be utilized to shape the plasma for optimum effect. Another form of helical coil based reactor is taught in U.S. Patent No. 5,800,688 issued to A. P. Lantsman et al.

Commercial processes for manufacturing tools and decorative products on low melting point metal products such as zinc or zinc alloys, often deposit a "seed" or "strike" layer or a plated metal layer or layers on the substrate before deposition of the decorative finish layer(s).

Typical materials formed by processes utilizing PVD reactors to form films on low melting point substrates include those listed below:

U.S. Patent No. 5,759,677 issued Klaus Fink, teaches articles having a base copper/nickel/chromium layer, a zirconium/cobalt layer and an additional layer of a nitride, carbide or oxide of zirconium, titanium, silicon or aluminum.

U.S. Patent No. 5,814,415 issued to S. R. Mcysan, III, teaches articles coated with a first nickel layer, then a palladium strike layer, then a palladium/nickel alloy layer, then a refractory metal strike layer of preferably zirconium and finally a layer of a refractory metal compound, for example, zirconium nitride.

U.S. Patent No. 5,879,532 issued to Dennis Foster et al, electroplates copper, nickel and/or chromium on the article, then utilizes PVD to deposit refractory metal compound on the electroplated layer.

Other references teaching the production of multi-layer coated articles include U.S. Patent No. 5,948,548 to R.P. Welty et al; U.S. Patent No. 6,106,958 to R. W. Sugg et al, U.S. Patent No. 6,132,889 to R. P. Welty et al and U.S. Patent No. 6,143,424 to P.B. Jonte et al.

A strike, seed or plated layer(s) is/are first deposited on the commercial products for a variety of reasons. These include improvement of film adhesion, reducing the stresses caused by differing coefficients of expansion between the substrate and the decorative film and reduction of galvanic corrosion at the interface between the substrate and the film layer. Sometimes a greater problem is "outgassing" of substrate atoms and ions, which corrupts the plasma composition and creates weaknesses in the resulting film structure. These weaknesses can lead to corrosion and/or discoloration, which can disfigure the film. Such weaknesses can even lead to corrosion beneath the film which can eventually cause local film separation or delamination of the film or other layers within the substrate.

These problems can be substantially and unexpectedly overcome by utilizing the process of this invention to manufacture a variety of objects including architectural hardware. This is particularly true where the decorative films are titanium nitroxides and zirconium nitroxides. These materials can have desirable titanium and zirconium nitride colors.

The problems and complexity associated with prior art film manufacturing methods rests on the fact that low melting temperature metal substrates, e.g., zinc, currently used in forming architectural and other commercial hardware can outgas unacceptably under exposure to conditions inherent in deposition of high melting point refractory metals, metal nitrides, carbides and oxides and nitroxides and similar ceramics.

### SUMMARY OF THE INVENTION

The invention is a method or process for depositing a specific type or types of film on a bare or unplated zinc or a bare or unplated zinc alloy substrate through physical vapor deposition. The film material will include at least one or more of the four (4) metals, chromium, nickel, titanium, or zirconium; or any combination of those four (4) metals; or a nitrate, carbide or nitroxide of any one of those four metals; or combinations of the four (4) metals and their nitrates, oxides, carbides or nitroxides.

### GENERAL TEACHING OF THE INVENTION

Decorative products having predetermined surface characteristics are formed in a vacuum chamber by exposing substrate surfaces to arc generated plasma particles of chrome, nickel, titanium and/or zirconium to directly deposit a film of predetermined decorative surface characteristics on unplated or bare zinc and unplated or bare zinc alloys. The films can be modified, where desired, by supplementary particles, introduced concurrently, into the plasma from non-arc-generated sources.

The process includes two steps. The first step is glow discharge or ion bombardment. The second step is coating by deposition of a "seed" layer, followed by deposition of a decorative layer or layers.

The first step of glow discharge or ion bombardment is used to impose a voltage across a gas, typically argon, nitrogen, and/or oxygen or a combination thereof to create a plasma, and thereafter to allow the created plasma to bombard the surface of the substrate with ions to clean, clear or prepare the substrate for the application of the desired films. This step is more completely explained hereafter.

The coating step or steps through the deposition of one or more films is/are the depositing of the plasma material removed from a cathode and deposited onto the substrate to form a film coating. This step is more completely explained hereafter.

The substrates or parts to be coated may be initially processed to obtain a desired surface texture or finish. Such surface treatments include, for example, sanding, polishing, buffing, scratching or other abrasion, techniques. In addition, substrates, where necessary, may be subjected to various cleaning methods and rinses to obtain a desired clean surface condition.

The parts are then loaded onto pylons or reels of a reactor. A preferred reactor is a model HTC 1500 manufactured by Hauzer Techno Coating of Venlo in the Netherlands (a magnetically steered cathode reactor) or any of a number of random arc reactors. After loading, the reactor is evacuated to a minimum vacuum of about 1X10⁻³ torr. The reactor chamber is then backfilled with a desired glow discharge or ion bombardment gas to a maximum pressure of about 5X10⁻² torr. A voltage is then applied between the electrode(s) and the reactor wall to form a plasma. This glow discharge or ion bombardment condition is then maintained for a period of two to twelve minutes.

At the completion of the glow discharge or ion bombardment cycle, process gases are Introduced and the cathode excitation voltage is applied to electrodes of desired metals to create arc sources. The arc source metal, known in the art as a "target" is a cathode. The cathode degrades through the implementation of an electrical arc on its surface and the degraded part of the cathode forms articles which contribute to forming a plasma zone. The plasma zone is maintained until a desired coating thickness of the film is obtained, i.e., generally from a minimum of about one thousand (1000) Angstroms to a maximum thickness of about twenty thousand (20,000) Angstroms. Preferred thicknesses range from about two thousand five hundred (2,500) Angstroms to about ten thousand (10,000) Angstroms for architectural hardware and other high quality cosmetic products. This coating step may be repeated with a variety of target materials or target material combinations and process gases or process gas combinations to produce one or more desired coating layers including "seed" coating layers and decorative coating layers.

A bias voltage of not less than twenty-five (25) Volts or more than eight hundred (800) Volts may be applied to the substrate to be coated. A preferred range of voltages is between forty (40) Volts and two-hundred (200) Volts. The plasma zone is maintained around the parts as the pylon, etc. rotate for a period of two (2) to twenty-five (25) minutes to obtain a desired metal or ceramic film thickness. The reactor is then vented, opened and finished articles are removed from the reactor.

Generally, films of predetermined composition are deposited from the plasma at a rate which generates a desired film thickness before the substrate temperature increases to a point that there is detrimental outgassing of substrate particles. The film deposition period can be lengthened, however, by use of external cooling during deposition.

The plasma zone will have a stoichiometry of film-forming particles consistent with formation of predetermined film compositions. Total particle density of the stoichiometrically chosen zone will vary with a) condensation conditions at the coating surface; b) outgassing rates and composition of particles from the substrate; c) substrate melting point; d) heat transfer rate from the cathodes and the plasma to the substrate; and e) reaction with any externally introduced reactive particles.

To maximize the desired uniformity of plasma particle densities, the arc generators are preferably steered. Additionally, arc sources can be spaced at different distances from the reactor walls so as to be complementary to the substrate configurations. Ancillary film components for forming colored metal finishes, for example, a simulated black nickel oxide finish, and inert gas sources, can also be positioned at desired locations within the reactor to enhance the formation of a uniform plasma. Such positioning of the arc sources, etc. is particularly beneficial where films are formed on large objects, for example, parts of three (3) to four (4) feet in height and widths varying from inches at a base to feet at different locations on an apex of the substrate.

Film thickness, as noted previously, ranges from about one thousand (1000) Angstroms to about twenty thousand (20,000) Angstroms and more preferably from about two thousand five hundred (2,500) Angstroms to about ten thousand (10,000) Angstroms. These film thicknesses are preferably obtained at deposition rates of about two hundred (200) to one thousand (1,000) Angstroms per minute and more preferably obtained at rates of about four hundred (400) to six hundred (600) Angstroms per minute using a preferred magnetically steered reactor type such as the earlier referenced Hauzer reactor. These deposition rates preclude unduly rapid heating of an average architectural hardware component. Unrefrigerated, thin work pieces may require lower rates while objects with relatively large mass can tolerate greater rates. For best results, substrate form should be considered at design because deposition is more difficult to control at, for example, points and sharp edges.

Substrates are placed at specific distances from the arc sources. These distances will preferably range from about one (1)-inch minimum to a maximum distance of about sixteen (16) inches at any time and more preferably will be about two and one half (2.5) inches minimum to ten (10) inches maximum. Maximum distances are determined by the minimally acceptable deposition rates without detrimental outgassing occurring.

### EXAMPLES:

1. A brass colored, zirconium nitride film is deposited on a zinc door lever in a reactor by hanging substrates such as levers on reels, closing the reactor door and opening the chamber to mechanical pumps capable of reducing the pressure to 1X10⁻³ torr. Next a glow discharge or ion bombardment argon gas is introduced at a flow rate of twenty-five (25) to eight hundred (800) sccm to create a plasma for two (2) to five (5) minutes. Once this step is complete, the glow discharge excitation voltage is removed, and a bias voltage is applied to the substrate(s). A separate voltage is applied to ignite the desired arc using a zirconium cathode with a minimum purity of ninety-nine per cent (99%) at the minimum cathode current necessary to ensure no more than two restrikes of any cathode per minute. The reactor is operated for one (1) to five (5) minutes to obtain a seed layer metal coating of desired thickness. Nitrogen is then introduced into the reaction chamber at the rate of eighty (80) to eight hundred (800) sccm for four (4) to sixteen (16) minutes with the application of a substrate bias voltage of not less than twenty-five (25) Volts or more than eight hundred (800) Volts, and then the arcs are extinguished. The reactor is typically purged with a nitrogen flow of five hundred (500) to three thousand (3,000) sccm for at least two (2) minutes. The reactor is then brought to atmospheric pressure and the zirconium nitride film-coated products are removed.
2. Zirconium carbide is applied to a substrate to provide a simulated black nickel finish on a zinc-based alloy using the reactor of Example 1. The reaction chamber is evacuated and the plasma ignited and coating conditions maintained from five (5) to twelve (12) minutes. Acetylene and/or methane is then introduced into the chamber at the rate of fifty (50) to eight-hundred (800) sccm gas flow. The reaction conditions are maintained for two (2) to ten (10) minutes, depending on desired film thickness, the arcs and hydrocarbon flow are terminated and nitrogen is introduced to flush the reactor. Finally, the vacuum is terminated and the blackened products removed.
3. The process of Example 1 is varied by substitution of titanium cathode electrodes and the introduction of oxygen for five (5) 5 to ten (10) minutes to produce a titanium nitrocarboxide coating having high electrical resistivity with color and opacity of the gold titanium nitrides.
4. The process of Example 3 is followed with the exception that zirconium electrodes are utilized to form brass colored films of high electrical resistivity.

## Claims

1. A process for depositing a film onto a bare or unplated zinc or zinc alloy substrate, the process comprising:
depositing a film onto a portion of the substrate by physical vapor deposition, the film being a metal film, a ceramic film or a combination thereof,
wherein the metal film includes chromium, nickel, titanium, zirconium or a combination thereof, and wherein the ceramic film includes a nitride, a carbide, an oxide or a nitroxide of chromium, nickel, titanium, zirconium, or a combination thereof.

2. The process of Claim 1 wherein the film is a metal film and the metal film includes chromium, nickel or a combination thereof.

3. The process of Claim 2 wherein the metal film is deposited at a maximum internal reactor pressure of about 5x10⁻² torr using a DC voltage ranging from about 25 Volts to about 600 Volts and at deposition rates of about 200 Angstroms to more than 1,000 Angstroms per minute to obtain film thicknesses ranging from about 1000 Angstroms to about 20,000 Angstroms.

4. The process of Claim 2, wherein the metal film is deposited at a maximum intemal reactor pressure of about 5x10⁻² Torr using a DC voltage ranging from about 40 Volts to about 200 Volts at deposition rates of about 400 Angstroms to more than 500 Angstroms per minute to obtain film thicknesses ranging from about 2,500 Angstroms to about 9,000 Angstroms.

5. The process of Claim 1 wherein the film is a ceramic film and the ceramic film includes a nitride, a carbide, an oxide or a nitroxide of titanium or zirconium.

6. The process of Claim 5 wherein the ceramic film is deposited at a maximum internal reactor pressure of about 5x10⁻² torr using a DC voltage ranging from about 25 Volts to about 600 Volts and at deposition rates of about 200 Angstroms to more than 1,000 Angstroms per minute to obtain film thicknesses ranging from about 1000 Angstroms to about 20,000 Angstroms.

7. The process of Claim 5, wherein the ceramic film is deposited at a maximum internal reactor pressure of about 5x10⁻² Torr using a DC voltage ranging from about 40 Volts to about 200 Volts at deposition rates of about 400 Angstroms to more than 500 Angstroms per minute to obtain film thicknesses ranging from about 2,500 Angstroms to about 9,000 Angstrom.

8. The process of Claim 1 wherein the film is a ceramic film including a nitride, a carbide, an oxide or a nitroxide of titanium.

9. The process of Claim 1 wherein the film is a ceramic film including a nitride, a carbide, an oxide or a nitroxide of zirconium.

10. The process of Claim 1 wherein the film is a ceramic film including a nitride. a carbide, an oxide or a nitroxide of both titanium and zirconium.

11. The process of Claim 1 wherein the film is a ceramic film including a nitride of chromium, nickel, titanium or zirconium.

12. The process of Claim 1 wherein the film is a ceramic film including a carbide of chromium, nickel, titanium or zirconium.

13. The process of Claim 1 wherein the film is a ceramic film including a nitroxide of chromium, nickel, titanium or zirconium .

14. The process of Claim 1 wherein the film is a metal film including chromium.

15. The process of Claim 1 wherein the film is a metal film including nickel.

16. The process of Claim 1 wherein the ceramic film has a thickness of from about 1,500 Angstroms to about 20,000 Angstroms.

17. A part comprising
a bare or unplated zinc or zinc alloy substrate; and
a film deposited directly onto a portion of the substrate by physical vapor deposition, the film being a metal film, a ceramic film or a combination thereof,
wherein the metal film includes chromium, nickel, titanium, zirconium or a combination thereof, and wherein the ceramic film includes a nitride, a carbide, an oxide or a nitroxide of chromium, nickel, titanium, zirconium or a combination thereof.

18. The part of Claim 17 wherein the film is a metal film, and the metal film includes chromium, nickel or a combination thereof.

19. The part of Claim 17 wherein the film is a ceramic film, and the ceramic film includes a nitride, a carbide, an oxide or a nitroxide of titanium or zirconium.

20. The part of Claim 19 wherein the ceramic film includes a nitroxide that is a good electrical conductor.

21. The part of Claim 19 wherein the ceramic film includes a nitroxide that is a poor electrical conductor.

22. The part of Claim 17 wherein the substrate is bare or unplated zinc.

23. The part of Claim 17 wherein the substrate is bare or unplated zinc alloy.

24. The part of Claim 17 wherein the film is a ceramic film and the ceramic film includes a nitride of chromium, nickel, titanium or zirconium.

25. The part of Claim 17 wherein the film is a ceramic film and the ceramic film includes a carbide of chromium, nickel, titanium or zirconium.

26. The part of Claim 17 wherein the film is a ceramic film and the ceramic film includes a nitroxide of chromium, nickel, titanium or zirconium.
